# EUROPEAN PATENT APPLICATION

(11) **EP 4 513 470 A1**
(43) Date of publication of application: **26.02.2025**
(21) Application number: 23846848.2
(22) Date of filing: 04.07.2023
(51) Int. Cl.: G09F 9/30, H04M 1/02, H10K 50/84, H10K 102/00

(54) **ELECTRONIC DEVICE COMPRISING FLEXIBLE DISPLAY**

(30) Priority: 25.07.2022 KR 20220091504; 02.09.2022 KR 20220111116
(71) Applicant: Samsung Electronics Co., Ltd., Suwon-si, Gyeonggi-do 16677 (KR)
(72) Inventor: SONG, Kwonho, Suwon-si, Gyeonggi-do 16677 (KR); JEONG, Hyeoncheol, Suwon-si, Gyeonggi-do 16677 (KR); CHOI, Seungbum, Suwon-si, Gyeonggi-do 16677 (KR); LEE, Wonho, Suwon-si, Gyeonggi-do 16677 (KR); JO, Jeonggyu, Suwon-si, Gyeonggi-do 16677 (KR)
(74) Representative: Gulde & Partner
(86) International application number: PCT/KR2023/009434
(87) International publication number: WO 2024/025189

(57) **Abstract**

An electronic device includes: a first housing; a second housing; a hinge device connecting the first housing and the second housing to be foldable relative to each other; and a flexible display supported by the first housing and the second housing, wherein the flexible display may include: a window layer; a display panel laminated under the window layer; a bending part bent from the display panel to a rear surface of the flexible display at a first edge of the flexible display; and a first filling member in a first space, within the electronic device, such as to surround at least a part of the first edge together with the bending part, wherein the first filling member is not within a second space between the window layer and the display panel.

## Description

### [Technical Field]

The disclosure relates to an electronic device including a flexible display.

### [Background Art]

An electronic device has gradually become slimmer, and has been improved so as to increase stiffness, reinforce a design thereof, and differentiate functional elements thereof at the same time. A shape of the electronic device has been deviated from a uniform rectangular shape, and has been gradually changed to various shapes. The electronic device may have a transformable structure which is convenient to carry and which can include a large-screen display. For example, as part of the transformable structure, the electronic device may include foldable housings which operate to fold or unfold with respect to each other. Such an electronic device may require a support structure which can reduce the deformation of the flexible display due to frequent folding operations.

### [Disclosure of Invention]

### [Technical Problem]

A foldable electronic device may include a hinge device (e.g., a hinge structure or hinge module), and a first housing and a second housing which are connected in a foldable manner in a direction in which they face each other through the hinge device. Such a foldable electronic device may operate in an in-folding and/or out-folding manner in which the first housing is rotated within a range of 0 to 360 degrees against the second housing through the hinge module. The foldable electronic device may include a flexible display disposed to be supported at least partly by the first housing and the second housing in an unfolded state of the foldable electronic device. Such a flexible display may include a plurality of layers (e.g., a protection layer, a polarization layer (POL), a polymer layer, or at least one functional layer) disposed on an upper surface and/or a lower surface based on a display panel.

For slimming of the foldable electronic device, a protection cover (e.g., deco cover or protection frame) disposed so that an edge part (e.g., an edge) of a display of the flexible display is invisible from an outside may be omitted. For example, in the electronic device from which the protection cover is omitted, the flexible display may be disposed so that edges thereof are visible from the outside while being supported by the first housing and the second housing.

In this case, since the edge part including a bending part (e.g., chip on panel or chip on plastic (COP)) extending from the display panel of the flexible display is vulnerable to an external impact, a malfunction may occur due to the damage thereof. Further, since static electricity (e.g., electrostatic discharge (ESD)) having entered into a space between the housings and the flexible display panel is induced along the bending part, it may electrically damage the display panel. Further, foreign substances or moisture having entered between the housings and the flexible display may enter between a plurality of layers of the flexible display, and thus the flexible display may be vulnerable to waterproofing.

According to various embodiments of the present disclosure, an electronic device including a flexible display may be provided that has improved durability against an external impact by the electronic device including a protection structure for a bending part of the display panel.

According to various embodiments of the present disclosure, an electronic device including a flexible display may be provided that includes a waterproofing structure for protection against external moisture or foreign substances.

According to various embodiments of the present disclosure, an electronic device may be provided that includes a flexible display having a protection structure that providessurface quality improvement in consideration of a slip amount of the flexible display and durability improvement against an external impact and folding.

However, problems solved by embodiments of the present disclosure are not limited to the above-mentioned problems, and other problems may be solved by embodiments of the present disclosure.

### [Solution to Problem]

According an aspect of the disclosure, an electronic device includes: a first housing; a second housing; a hinge connecting the first housing and the second housing to be foldable relative to each other; and a flexible display supported by the first housing and the second housing, wherein the flexible display may include: a window layer; a display panel laminated under the window layer; a bending part bent from the display panel to a rear surface of the flexible display at a first edge of the flexible display; and a first filling member in a first space, within the electronic device, such as to surround at least a part of the first edge together with the bending part, wherein the first filling member is not within a second space between the window layer and the display panel.

The first space and the second space may not overlap each other in a view of the flexible display from above.

The first filling member may include a molding solution that is cured.

The electronic device may further include: a polymer layer under the display panel; and a support plate under the polymer layer.

The first edge may face in a first direction towards the bending part, and at the first edge, an edge of the polymer layer that faces in the first direction may be a further in the first direction than an edge of the display panel that faces in the first direction.

The first edge faces in a first direction towards the bending part, and, at the first edge, an edge of the support plate that faces in the first direction may be further in the first direction than an edge of the polymer layer that faces in the first direction.

The electronic device may further include an adhesive member between at least a part of the window layer and the bending part at the first edge and blocking the second space.

The window layer may include a first layer of a polymer material and a second layer of a glass material, the second layer may be between the first layer and the bending part, and the electronic device may further include an adhesive member between at least a part of the first layer and the bending part at the first edge and blocking the second space.

The first filling member may have a molding modulus value that is equal to or larger than 100 Mpa.

The electronic device may further include a second filling member within the second space.

The second filling member may include a cured molding solution.

The second filling member may have a molding modulus value equal to or smaller than 10 Mpa.

The first housing may include: a first lateral member that forms at least a part of a side surface of the electronic device; and a first support member that extends from the first lateral member. The second housing may include: a second lateral member that forms at least another part of the side surface of the electronic device; and a second support member that extends from the second lateral member. The flexible display may be supported by the first support member and the second support member.

The first filling member may be within a space between the second lateral member and the second support member.

A size or a shape of the first filling member may be defined by a space between the second lateral member and the second support member.

According to an aspect of the disclosure, an electronic device includes: a first housing; a second housing; a hinge device connecting the first housing and the second housing to be foldable relative to each other; and a flexible display supported by the first housing and the second housing, wherein the flexible display may include: a window layer; a display panel laminated under the window layer; a bending part bent from the display panel to a rear surface of the flexible display at a first edge of the flexible display; a first filling member in a first space, within the electronic device, such as to surround at least a part of the first edge together with the bending part; and a second filling member in a second space, between the window layer and the display panel, and having a molding modulus value that is smaller than a molding modulus value of the first filling member.

The first space and the second space nay not overlap each other in a view of the flexible display from above.

The molding modulus value of the first filling member may be equal to or larger than 100 Mpa.

The molding modulus value of the second filling member may be equal to or smaller than 10 Mpa.

The electronic device of claim 16, further including at least two layers that are under the display panel, the first edge faces in a first direction towards the bending part, and, at the first edge, edges of the at least two layers that face in the first direction towards the bending part are farther in the first direction the farther the at least two layers are away from the display panel.

### [Advantageous Effects of Invention]

Since in the electronic device according to one or more exampleembodiments of the disclosure, the first filling member for protecting the bending part is disposed except for the space between the window layer and the display of the flexible display at the first edge including the bending part of the flexible display, or the second filling member having the molding modulus value that is smaller than that of the first filling member is filled in the corresponding space, it can help the durability improvement of the bending part and the surface quality improvement of the flexible display. Further, the improved protection structure against the ESD can be provided through the first filling member and/or the second filling member, and thus penetration of the external foreign substances and/or moisture can be suppressed.

In addition, various other effects of embodiments of the present disclosure will be understood by a person of ordinary skill in the art based on explicit and implicit descriptions in the present disclosure.

The effects that are obtained by embodiments of the present disclosure are not limited to the above-mentioned effects, and other unmentioned effects will be clearly understood by those of ordinary skill in the art to which the disclosure pertains from the following description.

### [Brief Description of Drawings]

The above and other aspects, features, and advantages of certain embodiments of the present disclosure will be more apparent from the following description taken in conjunction with the accompanying drawings, in which:
FIG. 1A is a front perspective view of an electronic device illustrating an unfolded state (or a flat state) according to various embodiments of the disclosure;
FIG. 1B is a plan view illustrating a front surface of an electronic device in an unfolded state according to various embodiments of the disclosure;
FIG. 1C is a plan view illustrating a rear surface of an electronic device in an unfolded state according to various embodiments of the disclosure;
FIG. 2A is a perspective view of an electronic device illustrating a folded state according to various embodiments of the disclosure;
FIG. 2B is a perspective view of an electronic device illustrating an intermediate state according to various embodiments of the disclosure;
FIG. 3 is an exploded perspective view of an electronic device according to various embodiments of the disclosure;
FIG. 4A is an exploded perspective view of a flexible display according to various embodiments of the disclosure;
FIG. 4B is a configuration diagram of a flexible display when viewed from a rear surface thereof according to various embodiments of the disclosure;
FIG. 5 is a partial cross-sectional view of an electronic device when viewed along line 5-5 of FIG; 1A according to various embodiments of the disclosure;
FIG. 6 is a process chart for applying filling members to a flexible display according to various embodiments of the disclosure;
FIGS. 7A to 7E are schematic diagrams illustrating a process for applying filling members to a flexible display according to various embodiments of the disclosure; and
FIGS. 8A to 8C are partial cross-sectional views of an electronic device according to various embodiments of the disclosure.

### [Mode for the Invention]

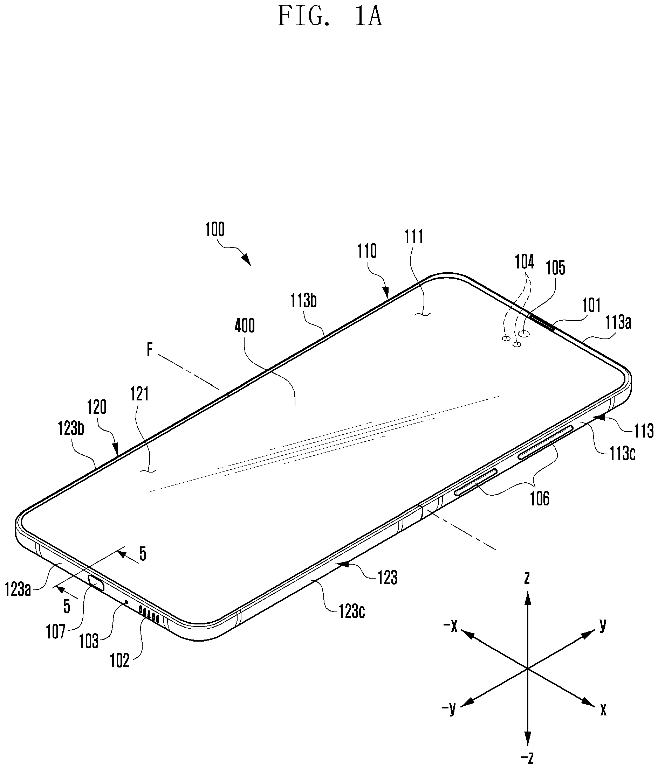

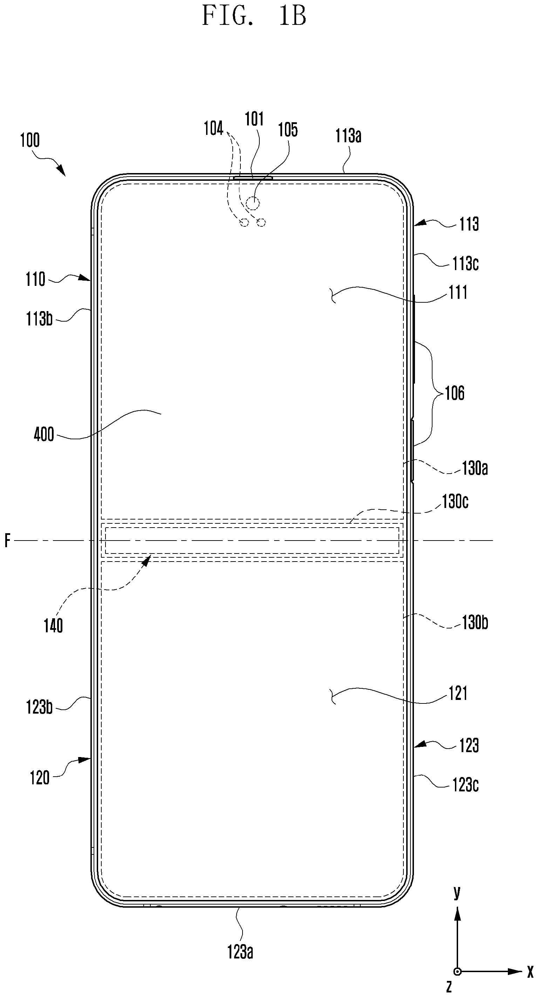

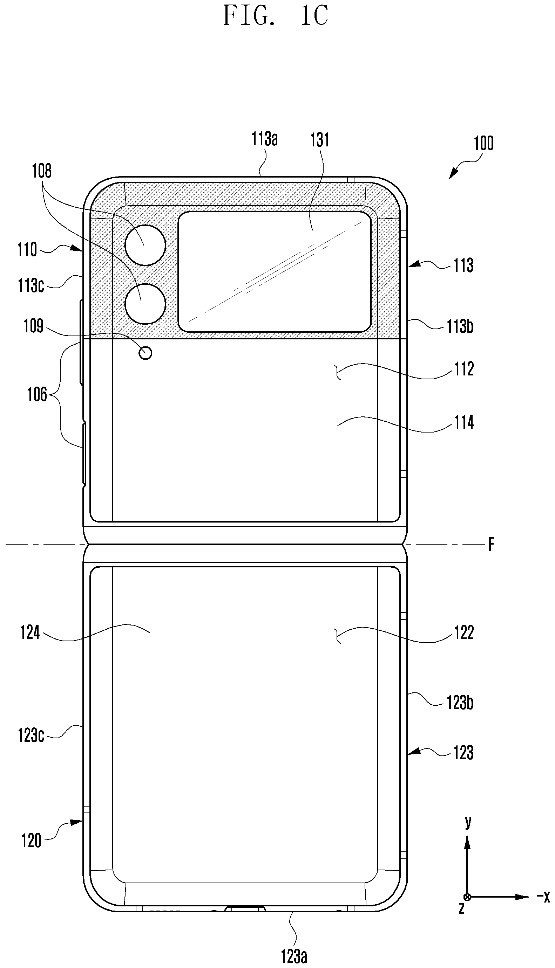

FIG. 1A is a perspective view of an electronic device illustrating an unfolded state (or a flat state) of the electronic device according to various embodiments of the disclosure. FIG. 1B is a plan view illustrating a front surface of an electronic device in an unfolded state of the electronic device according to various embodiments of the disclosure. FIG. 1C is a plan view illustrating a rear surface of an electronic device in an unfolded state according to various embodiments of the disclosure.

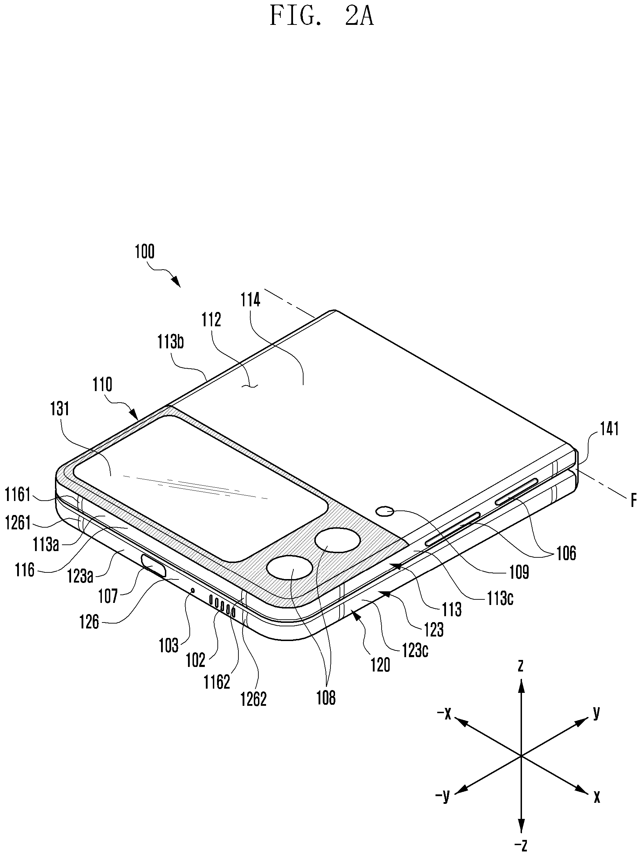

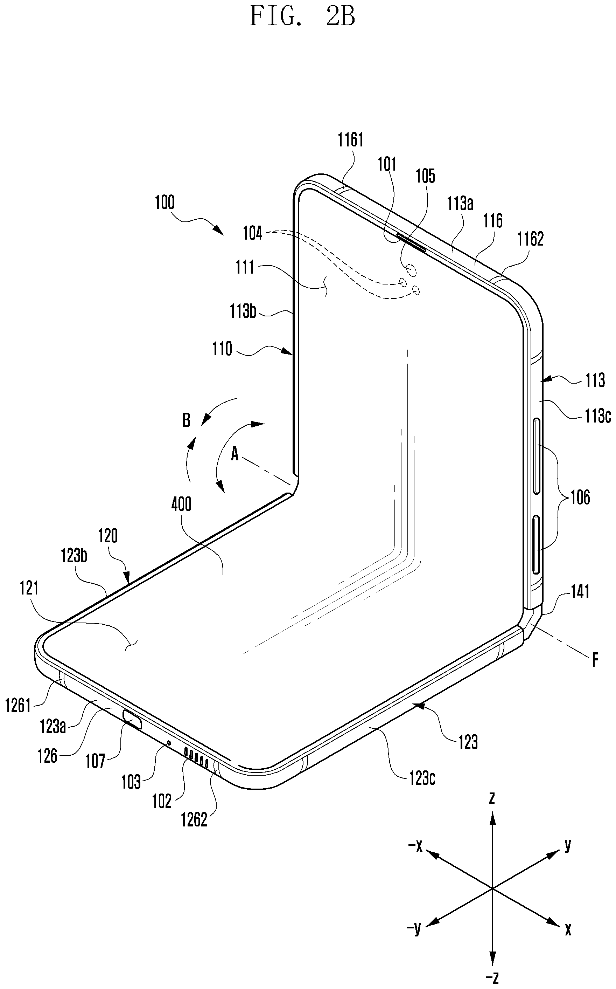

FIG. 2A is a perspective view of an electronic device illustrating a folded state of the electronic device according to various embodiments of the disclosure. FIG. 2B is a perspective view of an electronic device illustrating an intermediate state of the electronic device according to various embodiments of the disclosure.

With reference to FIGS. 1A to 2B, an electronic device 100 may include a first housing 110 and a second housing 120 (e.g., a foldable housing structure) combined with each other in a foldable manner based on a hinge device (e.g., hinge device 140 of FIG. 1B). In an embodiment, the hinge device (e.g., hinge device 140 of FIG. 1B) may be disposed in an X-axis direction or in a Y-axis direction. According to an embodiment, the electronic device 100 may include a first display 400 (e.g., a flexible display, a foldable display, or a main display) disposed in an area (e.g., a recess) formed by the first housing 110 and the second housing 120. According to an embodiment, the first housing 110 and the second housing 120 may be disposed on both sides around a folding axis F, and may have a substantially symmetrical shape about the folding axis F. According to an embodiment, an angle or a distance between the first housing 110 and the second housing 120 may differ depending on the state of the electronic device 100. For example, depending on whether the electronic device is in an unfolded state (or a flat state), in a folded state, or in an intermediate state, the angle or the distance between the first housing 110 and the second housing 120 may differ.

According to an embodiment, in the unfolded state of the electronic device 100, the first housing 110 may include a first surface 111 directed in a first direction (e.g., front direction) (z-axis direction), and a second surface 112 directed in a second direction (e.g., rear direction) (-z-axis direction) opposite to the first surface 111. According to an embodiment, in the unfolded state of the electronic device 100, the second housing 120 may include a third surface 121 directed in the first direction (z-axis direction), and a fourth surface 122 directed in the second direction (-z-axis direction). According to an embodiment, in the unfolded state of the electronic device 100, the first surface 111 of the first housing 110 and the third surface 121 of the second housing 120 may be directed in substantially the same first direction (z-axis direction). In an embodiment, in the folded state of the electronic device 100, the first surface 111 of the first housing 110 and the third surface 121 of the second housing 120 may face each other. According to an embodiment, in the unfolded state of the electronic device 100, the second surface 112 of the first housing 110 and the fourth surface 122 of the second housing 120 may be directed in substantially the same second direction (-z-axis direction). In an embodiment, in the folded state of the electronic device 100, the second surface 112 of the first housing and the fourth surface 122 of the second housing 120 may be directed in opposite directions. For example, in the folded state of the electronic device 100, the second surface 112 may be directed in the first direction (z-axis direction), and the fourth surface 122 may be directed in the second direction (-z-axis direction). In this case, the first display 400 may not be viewed from an outside (in-folding manner). In an embodiment, the electronic device 100 may be folded so that the second surface 112 of the first housing 110 and the fourth surface 122 of the second housing 120 face each other. In this case, the first display 400 may be disposed to be viewed from the outside (out-folding manner).

According to various embodiments, the first housing 110 (e.g., the first housing structure) may include a first lateral member 113 forming the appearance of the electronic device 100, and a first rear cover 114 combined with the first lateral member 113, and forming at least a part of the second surface 112 of the electronic device 100. According to an embodiment, the first lateral member 113 may include a first side surface 113a, a second side surface 113b extending from one end of the first side surface 113a, and a third side surface 113c extending from the other end of the first side surface 113a. According to an embodiment, the first lateral member 113 may be formed in a quadrangular (e.g., square or rectangular) shape defined by the first side surface 113a, the second side surface 113b, and the third side surface 113c.

According to various embodiments, the second housing 120 (e.g., second housing structure) may include a second lateral member 123 forming the appearance of the electronic device 100 at least partly, and a second rear cover 124 combined with the second lateral member 123, and forming at least a part of the fourth surface 122 of the electronic device 100. According to an embodiment, the second lateral member 123 may include a fourth side surface 123a, a fifth side surface 123b extending from one end of the fourth side surface 123a, and a sixth side surface 123c extending from the other end of the fourth side surface 123a. According to an embodiment, the second lateral member 123 may be formed in a quadrangular shape defined by the fourth side surface 123a, the fifth side surface 123b, and the sixth side surface 123c.

According to various embodiments, the first housing 110 and the second housing 120 are not limited to the illustrated shapes and combinations, and may be implemented by combinations and/or compositions of other shapes or components. In an embodiment, the first lateral member 113 may be integrally formed with the first rear cover 114, and the second lateral member 123 may be integrally formed with the second rear cover 124.

According to various embodiments, in the unfolded state of the electronic device 100, the second side surface 113b of the first lateral member 113 and the fifth side surface 123b of the second lateral member 123 may be connected to each other without a gap. According to an embodiment, in the unfolded state of the electronic device 100, the third side surface 113c of the first lateral member 113 and the sixth side surface 123c of the second lateral member 123 may be connected to each other without a gap. According to an embodiment, in the unfolded state of the electronic device 100, the sum of the lengths of the second side surface 113b and the fifth side surface 123b may be configured to be longer than the length of the first side surface 113a and/or the fourth side surface 123a. According to an embodiment, in the unfolded state of the electronic device 100, the sum of the lengths of the third side surface 113 c and the sixth side surface 123c may be configured to be longer than the length of the first side surface 113a and/or the fourth side surface 123a.

With reference to FIGS. 2A and 2B, the first lateral member 113 and/or the second lateral member 123 may be formed of metal, or may further include polymer that is injected into metal. According to an embodiment, the first lateral member 113 may include at least one conductive part 116 electrically segmented by at least one segment part 1161, 1162 formed of polymer, and/or the second lateral member 123 may include at least one conductive part 126electrically segmented by at least one segment part 1261, 1262 formed of polymer. In this case, the at least one conductive part 116 and/or the at least one conductive part 126 may be electrically connected to a wireless communication circuit included in the electronic device 100, and thus may be used as at least a part of an antenna that operates in at least one designated band (e.g., legacy band).

According to various embodiments, the first rear cover 114 and/or the second rear cover 124 may be formed of, for example, at least one of coated or colored glass, ceramic, polymer, or metal (e.g., aluminum, stainless steel (STS), or magnesium) or a combination of at least two thereof.

According to various embodiments, the first display 400 may be disposed to extend from the first surface 111 of the first housing 110 to at least a part of the third surface 121 of the second housing 120 across the hinge device (e.g., the hinge device 140 of FIG. 1B). In an embodiment, the first display 400 may include a first area 130a substantially corresponding to the first surface 111, a second area 130b corresponding to the second surface 112, and a third area 130c (e.g., a flexible area or a folding area) connecting the first area 130a and the second area 130b to each other. According to an embodiment, the third area 130c may be a part of the first area 120a and/or the second area 130b, and may be disposed at a location corresponding to the hinge device (e.g., the hinge device 140 of FIG. 1B). According to an embodiment, the electronic device 100 may include a hinge housing 141 (e.g., a hinge cover) supporting the hinge device (e.g., the hinge device 140 of FIG. 1B). In an embodiment, the hinge housing 141 may be disposed to be exposed to outside when the electronic device 100 is in a folded state, and not to be viewed from the outside as being drawn into an inner space of the first housing 110 and an inner space of the second housing 120 when the electronic device 100 is in an unfolded state.

According to various embodiments, the electronic device 100 may include a second display 131 (e.g., a sub-display) disposed separately from the first display 400. According to an embodiment, the second display 131 may be disposed to be exposed at least partly on the second surface 112 of the first housing 110. In an embodiment, when the electronic device 100 is in the folded state, the second display 131 may display at least a part of state information of the electronic device 100 in replacement of at least a part of a display function of the first display 400. According to an embodiment, the second display 131 may be disposed to be viewed from the outside through at least a partial area of the first rear cover 114. In an embodiment, the second display 131 may be disposed on the fourth surface 122 of the second housing 120. In this case, the second display 131 may be disposed to be viewed from the outside through at least a partial area of the second rear cover 124.

According to various embodiments, the electronic device 100 may include at least one of an input device 103 (e.g., a microphone(s)), sound output devices 101 and 102, a sensor module 104, camera devices (e.g., a first camera device 105 and a second camera device 108), a key input device 106, and/or a connector port 107. In an illustrated embodiment, although the input device 103 (e.g., a microphone), the sound output devices 101 and 102, the sensor module 104, the first camera device 105, the second camera device 108, the key input device 106, or the connector port 107 are illustrated as hole or circular shaped elements formed on the first housing 110 or the second housing 120, they are example illustrations for explanation, and are not limited thereto. According to various embodiments, the input device 103 may include at least one microphone disposed on the second housing 120. In an embodiment, the input devices 103 may include a plurality of microphones disposed to sense the sound direction. In an embodiment, the plurality of microphone may be disposed at proper locations on the first housing 110 and/or the second housing 120. According to an embodiment, the sound output devices 101 and 102 may include at least one speaker. According to an embodiment, the at least one speaker of the sound output device 101 may include a receiver for calls disposed on the first housing 110, and the speaker of the sound output device 102 may be disposed on the second housing 120. In an embodiment, the input device 103, the sound output devices 101 and 102, and the connector port 107 may be disposed in a space provided in the first housing 110 and/or the second housing 120 of the electronic device 100, and may be exposed to an external environment through at least one hole formed on the first housing 110 and/or the second housing 120. According to an embodiment, the at least one connector port 107 may be used to transmit and receive power and/or data to and from an external electronic device. In an embodiment, the at least one connector port (e.g., ear jack hole) may accommodate a connector (e.g., ear jack) for transmitting and receiving an audio signal to and from the external electronic device. In an embodiment, the hole formed on the first housing 110 and/or the second housing 120 may be commonly used for the input device 103 and the sound output devices 101 and 102. In an embodiment, the sound output devices 101 and 102 may include a speaker (e.g., piezo-electric speaker) that is not exposed through the hole formed on the first housing 110 and/or the second housing 120.

According to various embodiments, the sensor module 104 may generate an electrical signal or a data value corresponding to an internal operation state of the electronic device 100 or an external environment state. According to an embodiment, the sensor module 104 may detect the external environment through the first surface 111 of the first housing 110. In an embodiment, the electronic device 100 may further include at least one sensor module disposed to detect the external environment through the second surface 112 of the first housing 110. According to an embodiment, the sensor module 104 (e.g., an illumination sensor) may be disposed to detect the external environment through the first display 400 under the first display 400. According to an embodiment, the sensor module 104 may include at least one from among a gesture sensor, a gyro sensor, a barometric pressure sensor, a magnetic sensor, an acceleration sensor, a grip sensor, a color sensor, an infrared (IR) sensor, a biosensor, a temperature sensor, a humidity sensor, an illumination sensor, a proximity sensor, a biosensor, an ultrasonic sensor, and an illumination sensor.

According to various embodiments, the camera devices may include a first camera device 105 (e.g., a front camera device) disposed on the first surface 111 of the first housing 110, and a second camera device 108 disposed on the second surface 112 of the first housing 110. In an embodiment, the electronic device 100 may further include a flash 109 disposed near the second camera device 108. According to an embodiment, the first camera device 105 and the second camera device 108 may include at least one lens, an image sensor, and/or an image signal processor. According to an embodiment, the first camera device 105 and the second camera device 108 may be disposed so that two or more lenses (e.g., wide angle lens, ultra wide angle lens, or telephoto lens) and two or more image sensors are located on one surface (e.g., the first surface 111, the second surface 112, the third surface 121, and/or the fourth surface 122) of the electronic device 100. In an embodiment, the first camera device 105 and the second camera device 108 may include lenses for time of flight (TOF) and/or image sensors.

According to various embodiments, the key input device 106 (e.g., key buttons) may be disposed on the third side surface 113c of the first lateral member 113 of the first housing 110. In an embodiment, the key input device 106 may be disposed on at least one from among the first side surface 113a and/or the second side surface 113b of the first housing 110 and/or the fourth side surface 123a, the fifth side surface 123b, and the sixth side surface 123c of the second housing 120. In an embodiment, the electronic device 100 may not include some or all of the key input devices 106, and the non-included key input device(s) 106 may be implemented in another form, such as a soft key, on the first display 400. In an embodiment, the key input device 106 may be implemented by using the pressure sensor included in the first display 400.

According to various embodiments, one of the camera devices (e.g., the first camera device 105) or the sensor module 104 may be disposed to be exposed through the first display 400. According to an embodiment, the first camera device 105 or the sensor module 104 may be optically exposed to the outside through an opening (e.g., through-hole) formed at least partly on the first display 400 in the inner space of the electronic device 100. According to an embodiment, at least a part of the sensor module 104 may be disposed not to be visually exposed through the first display 400 in the inner space of the electronic device 100. With reference to FIG. 2B, the electronic device 100 may operate to maintain at least one designated folding angle in an intermediate state through the hinge device (e.g., the hinge device 140 of FIG. 1B). In this case, the electronic device 100 may control the first display 400 so that different kinds of content are displayed on the display area corresponding to the first surface 111 and the display area corresponding to the third surface 121. According to an embodiment, the electronic device 100 may operate in substantially the unfolded state (e.g., the unfolded state of FIG. 1A) and/or in substantially the folded state (e.g., the folded state of FIG. 2A) based on a specific folding angle (e.g., the angle between the first housing 110 and the second housing 120 when the electronic device 100 is in the intermediate state) through the hinge device (e.g., the hinge device 140 of FIG. 1B). **In** an embodiment, if a pressing force is provided in an unfolding direction (direction A) in a state where the electronic device 100 is unfolded at the specific folding angle through the hinge device (e.g., the hinge device 140 of FIG. 1B), the electronic device 100 may operate to be transitioned to the unfolded state (e.g., the unfolded state of FIG. 1A). **In** an embodiment, if the pressing force is provided in a folding direction (direction B) in a state where the electronic device 100 is unfolded at the specific folding angle through the hinge device (e.g., the hinge device 140 of FIG. 1B), the electronic device 100 may operate to be transitioned to the folded state (e.g., the folded state of FIG. 2A). In an embodiment, the electronic device 100 may operate to maintain the unfolded state at various angles through the hinge device (e.g., the hinge device 140 of FIG. 1B), which may be referred to as a free-stop function.

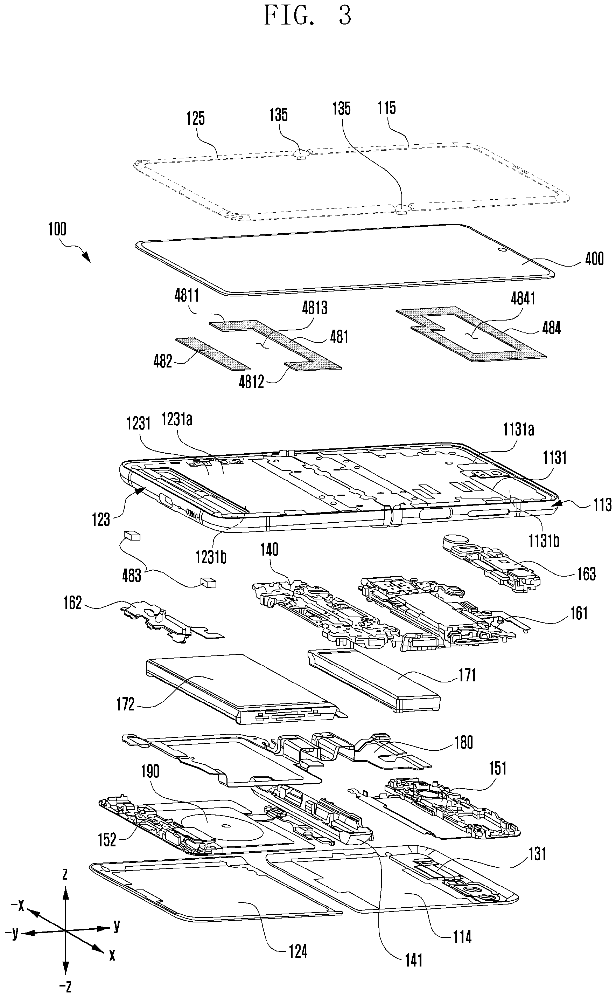

FIG. 3 is an exploded perspective view of an electronic device according to various embodiments of the disclosure.

With reference to FIG. 3, the electronic device 100 may include the first lateral member 113 (e.g., a first lateral frame), the second lateral member 123 (e.g., a second lateral frame), and the hinge device 140 (e.g., a hinge module or a hinge structure) rotatably connecting the first lateral member 113 and the second lateral member 123 to each other. According to an embodiment, the electronic device 100 may include a first support member 1131 (e.g., a first support plate) extending at least partly from the first lateral member 113, and a second support member 1231 (e.g., a second support plate) extending at least partly from the second lateral member 123. According to an embodiment, the first support member 1131 may be integrally formed with the first lateral member 113, or may be structurally combined with the first lateral member 113. In an embodiment, the second support member 1231 may be integrally formed with the second lateral member 123, or may be structurally combined with the second lateral member 123. According to an embodiment, the first display 400 may be disposed to be supported by the first support member 1131 and the second support member 1231. According to an embodiment, the electronic device 100 may include the first rear cover 114 combined with the first lateral member 113, and providing a first space together with the first support member 1131, and the second rear cover 124 combined with the second lateral member 123 and providing a second space together with the second support member 1231. In an embodiment, the first lateral member 113 and the first rear cover 114 may be integrally formed with each other. In an embodiment, the second lateral member 123 and the second rear cover 124 may be integrally formed. According to an embodiment, the first housing 110 may include the first lateral member 113, the first support member 1131, and the first rear cover 114. According to an embodiment, the second housing 120 may include the second lateral member 123, the second support member 1231, and the second rear cover 124. According to an embodiment, the electronic device 100 may include the second display 131 disposed to be viewed from the outside through at least a partial area of the first rear cover 114.

According to various embodiments, the electronic device 100 may include a first board 161 (e.g., a first board assembly or a main printed circuit board) disposed in the first space between the first lateral member 113 and the first rear cover 114, a camera assembly 163, a first battery 171, and/or a first bracket 151. According to an embodiment, the camera assembly 163 may include a plurality of camera devices (e.g., the camera device 105 and the second camera device 108 of FIGS. 1A and 2A), and may be electrically connected to the first board 161. According to an embodiment, the first bracket 151 may provide a support structure for supporting the first board 161 and/or the camera assembly 163 and improved stiffness. According to an embodiment, the electronic device 100 may include a second board 162 (e.g., a second board assembly or a sub-printed circuit board) disposed in the second space between the second lateral member 123 and the second rear cover 124, an antenna 190 (e.g., a coil member), a second battery 172, and/or a second bracket 152. According to an embodiment, the electronic device 100 may include a plurality of electronic components (e.g., a wiring member 180 (e.g., flexible printed circuit board (FPCB)) disposed to extend up to the second board 162, the second battery 172, and/or the antenna 190, and providing an electrical connection) disposed between the second lateral member 123 and the second rear cover 124 across the hinge device 140 from the first board 161. According to an embodiment, the antenna 190 may include a near field communication (NFC) antenna, a wireless charging antenna, and/or a magnetic secure transmission (MST) antenna.

According to various embodiments, the electronic device 100 may also include a first protection cover 115 (e.g., a first protection frame or a first decoration member) combined along an edge of the first housing 110, and a second protection cover 125 (e.g., a second protection frame or a second decoration member) combined along an edge of the second housing 120. According to an embodiment, the first protection cover 115 and/or the second protection cover 125 may be formed of a metal or polymer material. According to an embodiment, the first protection cover 115 and/or the second protection cover 125 may be used as the decoration members. In this case, the first display 400 may be disposed so that the edge of the first area 130a is not viewed from the outside between the first housing 110 and the first protection cover 115. According to an embodiment, the first display 400 may be disposed so that the edge of the second area 130b is not viewed from the outside between the second housing 120 and the second protection cover 125.

According to various embodiments, the electronic device 100 may also include a protection cap 135 disposed to protect the edge of the third area (e.g., the third area 130c of FIG. 1B) of the first display 400. In this case, the edge of the first display 400 can be protected by the protection cap 135 disposed at a location corresponding to the folding area (e.g., the third area 130c of FIG. 1B).

According to various embodiments, the first support member 1131 may include a first support surface 1131a directed in the first direction (z-axis direction), and a second support surface 1131b directed in the second direction (-z-axis direction) that is opposite to the first direction. According to an embodiment, the second support member 1231 may include a third support surface 1231a directed in the first direction and a fourth support surface 1231b directed in the second direction in the unfolded state of the electronic device 100. According to an embodiment, the first display 400 may be disposed to be supported by the first support surface 1131a of the first support member 1131 and the third support surface 1231a of the second support member 1231.

According to various embodiments, the electronic device 100 may include at least one waterproof member (e.g., a first waterproof member 481, a second waterproof member 482, a third waterproof member 483, and a fourth waterproof member 484) disposed between the first display 400 and the second support member 1231 and between the first display 400 and the first support member 1131. According to an embodiment, the waterproof members may include the first waterproof member 481 disposed between the first display 400 and the second support member 1231, the second waterproof member 482 connected to the first waterproof member 481, and the third waterproof member 483 that provides a first waterproof space 4813 by connecting one end 4811 of the first waterproof member 481 to one end of the second waterproof member 482 and by connecting the other end 4812 of the first waterproof member 481 to the other end of the second waterproof member 482. In an embodiment, the first waterproof member 481, the second waterproof member 482, and/or the third waterproof member 483 may be integrally formed. According to an embodiment, the waterproof members may include the fourth waterproof member 484 that provides a second waterproof space 4841 in the shape of a closed loop disposed between the first display 400 and the first support member 1131. According to an embodiment, a plurality of electronic elements including a control circuit (e.g., display driver IC (DDI)) of the first display 400 are disposed in the first waterproof space 4813, that is sealed and formed by the first waterproof member 481, the second waterproof member 482, and the third waterproof member 483 between the first display 400 and the second support member 1231, and thus can be protected from external moisture and/or foreign substances. According to an embodiment, at least one electronic component (e.g., a sensor module (e.g., the sensor module 104 of FIG. 1A) and/or a camera device (e.g., the first camera device 105 of FIG. 1A)) disposed through the first support member 1131 is disposed in the second waterproof space 4841 formed by the closed loop shape of the fourth waterproof member 484 between the first display 400 and the first support member 1131, and thus can be protected from the external moisture and/or foreign substances. The kinds of the constituent elements disposed in the first waterproof space 4813 and/or the second waterproof space 4841 according to various embodiments are not limited.

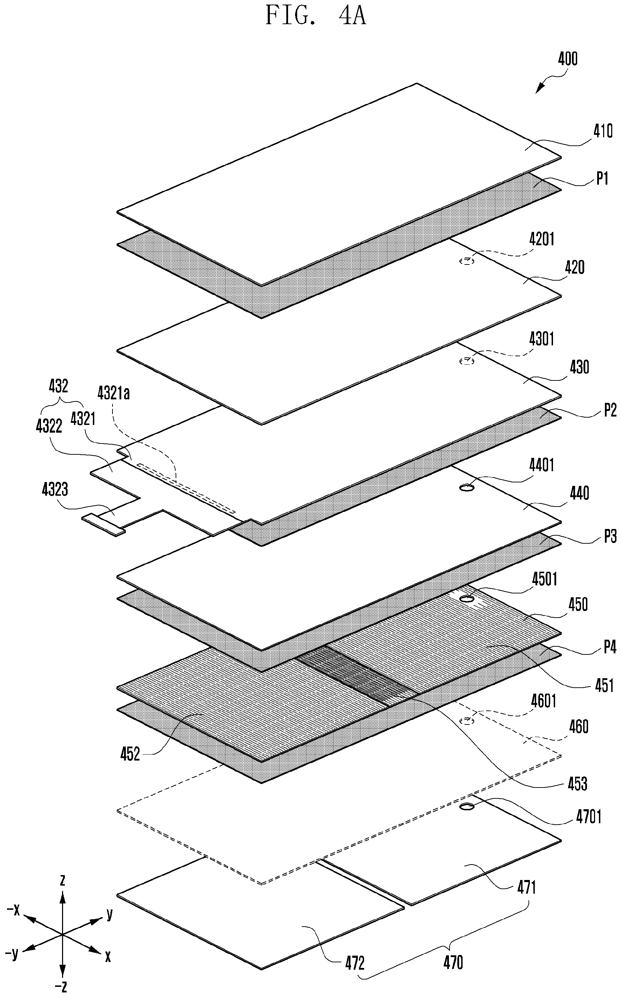

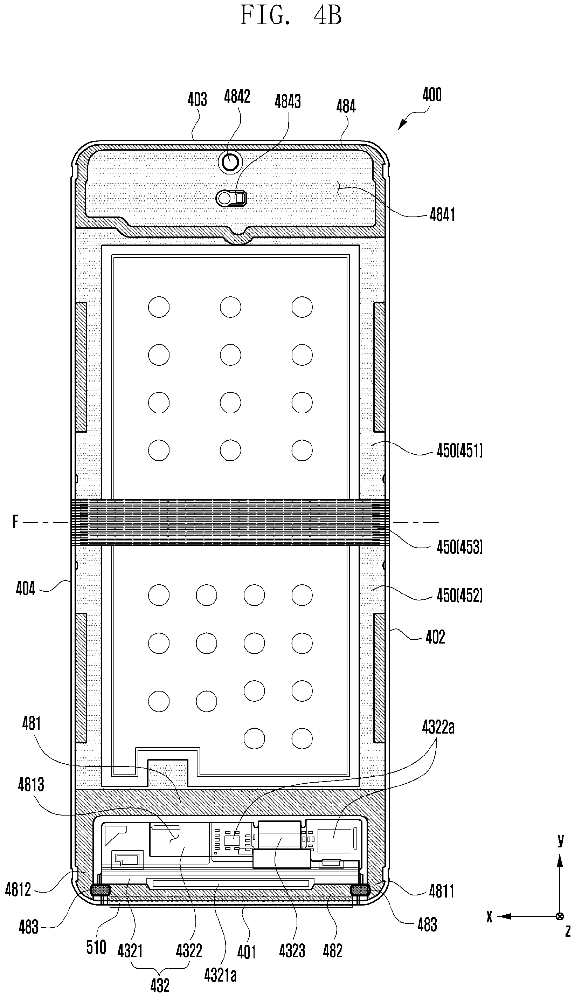

FIG. 4A is an exploded perspective view of a flexible display according to various embodiments of the disclosure. FIG. 4B is a configuration diagram of a flexible display when viewed from a rear surface thereof according to various embodiments of the disclosure.

The first display 400 of FIGS. 4A and 4B may be a flexible display and may be the same or similar to the first display 400 of FIG. 1A at least partly, or may further include other embodiments of the first display.

The display (e.g., the first display 400) according to non-limiting example embodiments of the disclosure may include an unbreakable (UB) type OLED display (e.g., curved display). However, the first display 400 is not limited thereto, and may include an unbreakable (UB) type OLED display (e.g., curved display). However, the display is not limited thereto, and the first display 400 may include a flat type display of an on cell touch active matrix organic light-emitting diode (AMOLED) (OCTA) type.

With reference to FIGS. 4A and 4B, the first display 400 may include a polarization layer (polarizer (POL)) 420 (e.g., a polarization film) sequentially disposed on the rear surface (e.g., -z-axis direction) of a window layer 410, a display panel 430, a polymer layer 440, a support plate 450, and reinforcement plates 471 and 472. In a certain embodiment, the first display 400 may also include a digitizer 460 disposed between the support plate 450 and the reinforcement plates 471 and 472. In a certain embodiment, the digitizer 460 may be disposed between the polymer layer 440 and the support plate 450. For example, in case that the first display 400 is a POL-less display, the polarization layer may be omitted, and a transparent reinforcement layer (e.g., a buffer layer) may be further disposed at that location. In a certain embodiment, the reinforcement plates 471 and 472 may be omitted.

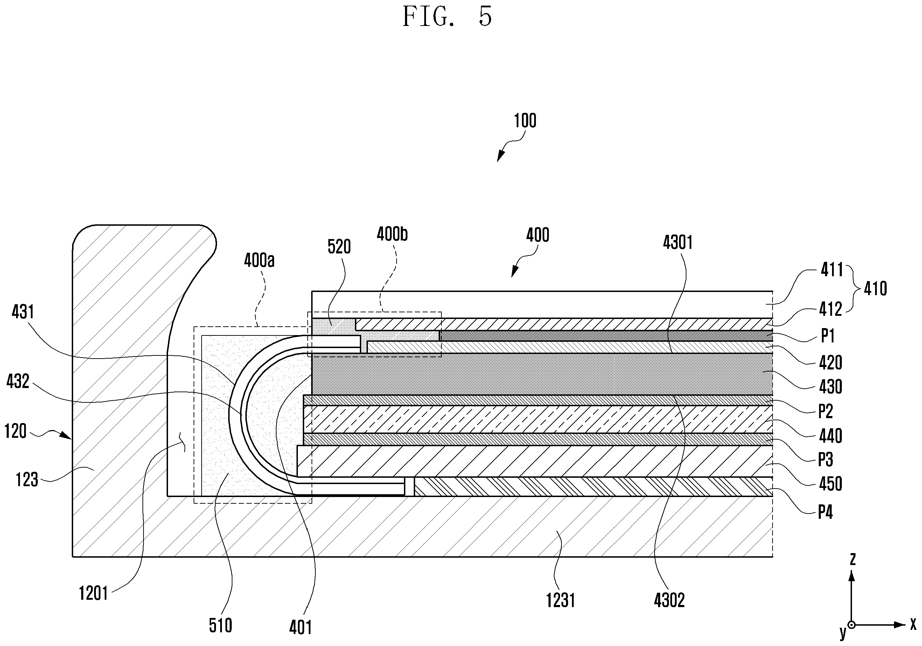

According to various embodiments, the window layer 410 may include a first layer (e.g., a first layer 411 of FIG. 5) and a second layer (e.g., a second layer 412 of FIG. 5) which are sequentially laminated. According to an embodiment, the first layer 411 may be formed of polymer (e.g., polyethylene terephthalate (PET), polyimide (PI), or thermoplastic polyurethane (TPU)). According to an embodiment, the second layer 412 may be formed of glass. According to an embodiment, the second layer may include ultrathin glass (UTG). In a certain embodiment, the first display 400 may be formed as a part of the window layer 410, and may further include a coating layer disposed on an upper part of the first layer 411. In this case, the coating layer may include a hard coating (HC) layer, an anti-reflection (AF) / low-reflection (LR) coating layer, a shatterproof (SP) coating layer, or an anti-fingerprint (AF) coating layer. In a certain embodiment, the coating layer may be formed on at least one part between the first layer 411 and the second layer 412, a side surface of the first layer 411, and/or a rear surface or a side surface of the second layer 412.

According to various embodiments, the window layer 410, the polarization layer 420, the display panel 430, the polymer layer 440, and the support plate 450 may be disposed to cross at least parts of the first surface (e.g., the first surface 111 of FIG. 1A) of the first housing (e.g., the first housing 110 of FIG. 1A) and the third surface (e.g., the third surface 121 of FIG. 1A) of the second housing (e.g., the second housing 120 of FIG. 1A). According to an embodiment, the reinforcement plate 471 may be a first reinforcement plate corresponding to the first housing (e.g., the first housing 110 of FIG. 1A), and the reinforcement plate 472 may be a second reinforcement plate corresponding to the second housing (e.g., the second housing 120 of FIG. 1A). According to an embodiment, the reinforcement plates 471 and 472 may provide the stiffness for the first display 400, and may be used as a ground for preventing malfunction of the first display 400. According to an embodiment, the reinforcement plates 471 and 472 may be formed of a metal material. According to an embodiment, the reinforcement plates 471 and 472 may be formed of steel use stainless (SUS) or Al. According to an embodiment, the window layer 410, the polarization layer 420, the display panel 430, the polymer layer 440, the support plate 450, and the reinforcement plates 471 and 472 may be attached to one another by adhesive members P1, P2, P3, and P4 (or adhesives). For example, the adhesive members P1, P2, P3, and P4 may include at least one of an optical clear adhesive (OCA), a pressure sensitive adhesive (PSA), a thermal reaction adhesive, a general adhesive, or a double-sided tape.

According to various embodiments, the display panel 430 may include a plurality of pixels and a wiring structure (e.g., electrode pattern). According to an embodiment, the polarization layer 420 may selectively pass light generated from a light source of the display panel 430 and vibrating in a predetermined direction. According to an embodiment, the display panel 430 and the polarization layer 420 may be integrally formed with each other. According to an embodiment, the first display 400 may also include a touch panel (not illustrated).

According to various embodiments, since the polymer layer 440 is disposed under the display panel 430, it may provide a dark background for securing visibility of the display panel 430, and may be formed of a buffer material for a buffering action. In a certain embodiment, for waterproofing of the first display 400, the polymer layer 440 may be omitted, or may be disposed under the support plate 450. In a certain embodiment, the polymer layer 440 may be omitted in case that the support plate 450 is formed of an opaque material.

According to various embodiments, the support plate 450 may provide the flexural characteristic to the first display 400. For example, the support plate 450 may be formed of a non-metal thin plate material, such as fiber reinforced plastics (FRP) (e.g., carbon fiber reinforced plastics (CFRP) or glass fiber reinforced plastics (GFRP)), having the rigid characteristic for supporting the display panel 430. According to an embodiment, the support plate 450 may include a first plane part 451 corresponding to the first housing (e.g., the first housing 110 of FIG. 1A), a second plane part 452 corresponding to the second housing (e.g., the second housing 120 of FIG. 1A), and a flexible part 453 (a flexible portion or a bending portion) connecting the first plane part 451 and the second plane part 452 to each other. According to an embodiment, in order to improve the flexibility, the flexible part 453 may include a plurality of openings formed to penetrate from the upper surface to the rear surface of the support plate 450 and/or a plurality of recesses formed on a part of the upper surface and/or a part of the rear surface thereof. According to an embodiment, the flexibility characteristic of the flexible part 453 may be determined based on at least from among the size, shape, and disposition density of at least some of the plurality of openings and/or at least some of the plurality of recesses. In a certain embodiment, the support plate 450 may be formed of a metal material, such as steel use stainless (SUS) (e.g., stainless steel (STS), Cu, Al, or CLAD (e.g., laminated member in which SUS and Al are alternately disposed). In this case, the plurality of openings may be formed over the whole area so that the detection operation of the digitizer 461 disposed under the support plate 450 is induced. According to an embodiment, the support plate 450 may help the stiffness reinforcement of the electronic device (e.g., the electronic device 100 of FIG. 1A), shield from surrounding noises, and be used to disperse heat emitted from surrounding heat emission components.

According to various embodiments, the first display 400 may include a digitizer 460 disposed under the support plate 450 as a detection member accommodating an input of an electronic pen (e.g., a stylus pen). According to an embodiment, the digitizer 460 may include coil members disposed on a dielectric board (e.g., a dielectric film or a dielectric sheet) so as to detect an electromagnetic induction type resonance frequency applied from the electronic pen. In a certain embodiment, the digitizer 460 may include a first digitizer disposed in an area corresponding to the first housing (e.g., the first housing 110 of FIG. 1A), and a second digitizer electrically connected to the first digitizer and disposed in an area corresponding to the second housing (e.g., the second housing 120 of FIG. 1A).

According to various embodiments, the first display 400 may include at least one functional member disposed between the polymer layer 440 and the support plate 450, or under the support plate 450. According to an embodiment, the functional member may include a graphite sheet for heat dissipation, a force touch FPCB, a fingerprint sensor FPCB, an antenna radiator for communication, or a conductive/non-conductive tape. According to an embodiment, in case that the functional member is unable to be bent, it may be individually disposed on the first housing (e.g., the first housing 110 of FIG. 1A) and the second housing (e.g., the second housing 120 of FIG. 1A). According to an embodiment, in case that the functional member is able to be bent, it may be disposed from the first housing (e.g., the first housing 110 of FIG. 1A) to at least a part of the second housing (e.g., the second housing 120 of FIG. 1A) through the hinge device (e.g., the hinge device 140 of FIG. 3).

According to various embodiments, the first display 400 may be formed in a quadrangular shape. According to an embodiment, the first display 400 may include a first edge 401, a second edge 402 extending in a vertical direction from the first edge 401, a third edge 403 extending in a direction parallel to the first edge 401 from the second edge 402, and a fourth edge 404 extending from the third edge 403 to the first edge 401. According to an embodiment, the first edge 401 may be disposed at a location corresponding to the fourth side surface (e.g., the fourth side surface 123a of FIG. 1A) of the second housing (e.g., the second housing 120 of FIG. 1A). According to an embodiment, the second edge 402 may be disposed at a location corresponding to the second side surface (e.g., the second side surface 113b of FIG. 1A) of the first housing (e.g., the first housing 110 of FIG. 1A) and the fifth side surface (e.g., the fifth side surface 123b of FIG. 1A) of the second housing (e.g., the second housing 120 of FIG. 1A). According to an embodiment, the third edge 403 may be disposed at a location corresponding to the first side surface (e.g., the first side surface 113a of FIG. 1A) of the first housing (e.g., the first housing 110 of FIG. 1A). According to an embodiment, the fourth edge 404 may be disposed at a location corresponding to the third side surface (e.g., the third side surface 113c of FIG. 1A) of the first housing (e.g., the first housing 110 of FIG. 1A) and the sixth side surface (e.g., the sixth side surface 123c of FIG. 1A) of the second housing (e.g., the second housing 120 of FIG. 1A). According to an embodiment, the first display 400 may include a bending part 432 disposed so as to be folded from the display panel 430 to at least a partial area of the rear surface (e.g., -z-axis direction) of the first display 400. According to an embodiment, the bending part 432 may include an extension part 4321 extending from the display panel 430 and including a control circuit 4321a and a flexible board 4322 electrically connected to the extension part 4321 and including a plurality of electronic elements. According to an embodiment, the control circuit 4321a may include a display driver IC (DDI) or a touch display driver IC (TDDI) mounted on the extension part 4321 having an electrical wiring structure. According to an embodiment, the bending part 432 may include a chip on panel or chip on plastic (COP) structure in which the control circuit 4321a is directly disposed on the extension part 4321. In a certain embodiment, the bending part 432 may include a chip on film (COF) structure in which the control circuit 4321a is mounted on a separate connection film (not illustrated) that connects the extension part 4321 and the flexible board 4322 to each other. In an embodiment, the flexible display 230 may include a plurality of electronic elements (e.g., the electronic elements 4322a of FIG. 4B) disposed on the flexible board 4322. According to an embodiment, the flexible display 230 may include an FPCB connection part 4323 (e.g., a connector part) extending from the flexible board 4322 and electrically connected to the board (e.g., the second board 162 of FIG. 3) of the electronic device (e.g., the electronic device 100 of FIG. 3). According to an embodiment, the plurality of electronic elements may include a touch IC, a flash memory for display, a diode for preventing the ESD, a pressure sensor, a fingerprint sensor, or a passive element such as a decap. As another embodiment, in case that the bending part 432 is disposed on the area of the first display 400 that faces the first housing (e.g., the first housing 110 of FIG. 1A), the FPCB connection part 4323 may be electrically connected to another board (e.g., the first board 161 of FIG. 3) of the electronic device (e.g., the electronic device 100 of FIG. 3).

According to various embodiments, the electronic device (e.g., electronic device 100 of FIG. 3) may include at least one waterproof member. According to an embodiment, the at least one waterproof member may include the first waterproof member 481, the second waterproof member 482, and the third waterproof member 483 corresponding to at least a part of the second housing (e.g., the second housing 120 of FIG. 1A), and disposed to form a first waterproof space 4813 for substantially protecting the control circuit 4321a disposed on the extension part 7321 of the bending part 432 and the plurality of electronic elements 4322a disposed on the flexible board 4322 from the external moisture and/or the foreign substances. According to an embodiment, the at least one waterproof member may include the fourth waterproof member 484 disposed to correspond to the at least a part of the second housing. According to an embodiment, the fourth waterproof member 484 may provide a second waterproof space 4841 that is sealed. According to an embodiment, the electronic device (e.g., the electronic device 100 of FIG. 1A may include at least one electronic component disposed in a first disposition area 4842 and a second disposition area 4843 provided in at least a partial area of the second waterproof space 4841. According to an embodiment, the at least one electronic component may include a camera device (e.g., the first camera device 105 of FIG. 1A) disposed in the first disposition area 4842, and a sensor module (e.g., the sensor module 104 of FIG. 1A) disposed in the second disposition area 4843.

According to a non-limiting example embodiment of the disclosure, the electronic device (e.g., the electronic device 100 of FIG. 1A) may include a first filling member 510 (refer to FIG. 5) disposed to surround at least the bending part 432 at the first edge 401 of the first display 400. According to an embodiment, the first filling member 510 may be formed by curing a molding liquid injected through a molding injector. According to an embodiment, the cured molding liquid may be disposed to protect the bending part 432 as the first filling member 510 (e.g., a hard molding) having a designated molding modulus value. For example, the molding modulus value of the first filling member 510 is equal to or larger than about 100 Mpa, and thus may help improve durability of the bending part 432 to endure an external impact.

According to various comparative embodiments, if the first filling member 510 of a hard material having the molding modulus value of 100 Mpa or more fills up the space between the window layer 410 and the display panel 430, a natural slip phenomenon between respective layers of the first display 400 according to the folding operation may be suppressed, and because of this, a buckling phenomenon may occur near the first filling member 510 to deteriorate the surface quality of the first display 400. Accordingly, according to a non-limiting example embodiment of the disclosure, with respect to the space (e.g., including a space including a POL) between the window layer 410 and the display panel 430, the first filling member 510 may not be applied, and/or the second filling member of a soft material (e.g., a second filling member 520 of FIG. 5) (e.g., soft molding) having a smaller molding modulus value than the molding modeling of the first filling member 510 may be applied. For example, since the molding modulus value of the second filling member 520 is equal to or smaller than about 10 Mpa, it is possible to accommodate the slip phenomenon that occurs during the folding, and to help improve the surface quality of the first display 400.

FIG. 5 is a partial cross-sectional view of an electronic device when viewed along line 5-5 of FIG. 1A according to various embodiments of the disclosure.

With reference to FIG. 5, an electronic device 100 may include a first housing (e.g., the first housing 110 of FIG. 1A), a second housing 120 combined in a foldable manner with the first housing 110 by a hinge device (e.g., the hinge device 140 of FIG. 3), and a first display 400 disposed to be supported by the first housing 110 and the second housing 120. According to an embodiment, the first display 400 may include a display panel 430, a POL 420 sequentially laminated on an upper surface 4301 of the display panel 430, a window layer 410, a polymer layer 440 sequentially laminated on a rear surface 4302 of the display panel 430, and a support plate 450. According to an embodiment, the window layer 410, the polarization layer 420, the display panel 430, the polymer layer 440, and the support plate 450 may be attached to one another by adhesive members P1, P2, P3, and P4 (or adhesives). In a certain embodiment, the support plate 450 may be attached to reinforcement plates (e.g., the reinforcement plates 470 of FIG. 4) disposed between the support plate 450 and the first housing 110 and the second housing 120 through the adhesive member. According to an embodiment, the window layer 410 may include a first layer 411 (e.g., PET layer or TPU layer) formed of polymer, and a second layer 412 (e.g., UTG layer) disposed under the first layer 411 and formed of glass.

According to various embodiments, the first display 400 may be disposed so that at least a part of the first display 400 is supported by a second lateral member 123 and a second support member 1231 extending from the second lateral member 123 to an inner space 1201 of the second housing. According to an embodiment, the first display 400 may include a bending part 432 (e.g., COP or COF) extending from the display panel 430 and being bent to a rear surface of the first display 400 at a first edge 401 corresponding to the fourth side surface (e.g., the fourth side surface 123a of FIG. 1A) of the second housing 120. According to an embodiment, the bending part 432 may be protected by a protection layer 431. According to an embodiment, the electronic device 100 may include a first filling member 510 disposed in a first space 400a surrounding at least the bending part 432, and a second filling member 520 disposed in a second space 400bbetween the window layer 410 and the display panel 430 in an inner space 1201 of the second housing 120. According to an embodiment, the first space 400a may include a part of the space 1201 between the first edge 401 of the first display 400 and the second lateral member 123 of the second housing 120. According to an embodiment, the first space 400a may include the bending part 432, and may include a space that comes in contact with the layers (e.g., polymer layer 440 and/or support plate 450) laminated on the rear surface 4302 of the display panel 430 at the first edge 401 of the first display 400. According to an embodiment, the first space 400a may not include the layers (e.g., POL 420 and/or window layer 410) laminated on the upper surface 4301 of the display panel 430. According to an embodiment, the second space 400b may include a space between the layers laminated on the upper surface 4301 of the first display 400. According to an embodiment, the second space 400b may include a space between the window layer 410 and the display panel 430. According to an embodiment, the first space 400a and the second space 400b may not overlap each other. According to an embodiment, the first space 400a may not overlap the second space 400b when the first display 400 is viewed from above. In a certain embodiment, the first space 400a may be disposed to overlap the second space 400b at least partly.

According to an embodiment, the first filling member 510 and the second filling member 520 may be formed by curing a molding liquid injected through a molding injector. For example, the molding liquid may be cured through at least one of natural curing, heat curing, or UV curing. According to an embodiment, the first filling member 510 and the second filling member 520 may be formed to have different molding modulus values. According to an embodiment, the first filling member 510 may have the strength for improving durability of the bending part 432 against external impacts. For example, the first filling member 510 may be formed of a material having the molding modulus value of about 100 Mpa or more when the molding liquid is cured. According to an embodiment, the first filling member 510 may be cured through an epoxy series molding liquid. According to an embodiment, the first filling member 510 cured in the first space 400a may help improve durability for protecting the bending part 432 without suppressing the slip phenomenon depending on the folding/unfolding operation of the electronic device 100.

According to various embodiments, when the molding liquid is injected to form the first filling member 510, the respective layers (e.g., the display panel 430, the polymer layer 440, and the support plate 450) of the first display 400 may be formed to have a positive step difference structure for uniform application thereof at the first edge 401. According to an embodiment, each of the layers (e.g., the display panel 430, the polymer layer 440, and the support plate 450)may be disposed so that edges of the layers disposed under the corresponding layer can be viewed at the first edge 401 when the first display 400 is viewed from above. For example, the polymer layer 440 may be disposed closer to the bending part 432 than the display panel 430 at the first edge 401 when the first display 400 is viewed from above. According to an embodiment, the support plate 450 may be disposed closer to the bending part 432 than the polymer layer 440 at the first edge when the first display 400 is viewed from above.

According to various embodiments, the second filling member 520 that fills the second space 400b may be formed of a material having the molding modulus value of about 10 Mpa or less when the molding liquid is cured. In a certain embodiment, the second filling member 520 may be formed of a material having the molding modulus value of about 5 Mpa or less when the molding liquid is cured. In a certain embodiment, the second filling member 520 may be formed of a material having the molding modulus value of about 1 Mpa or less when the molding liquid is cured. According to an embodiment, the second filling member 520 may be cured through a silicone series molding liquid. According to an embodiment, since the second filling member 520 accommodates the slip phenomenon between the layers (e.g., window layer 410 and display panel 430) of the first display 400 that occurs by the folding/unfolding operation of the electronic device 100, the occurrence of inferiority, such as the buckling phenomenon, can be reduced to help improve the surface quality of the first display 400. According to an embodiment, since the second filling member 520 that fills the second space 400b blocks the second space 400b between the window layer 410 and the display panel 430 at the first edge 401 of the first display 400, it is possible to provide an improved protection structure against the electrostatic discharge (ESD) that flows from the outside to the display panel 430 through the bending part 432, and to help the improvement of the waterproof performance through suppressing of the penetration of the external foreign substances and/or moisture. In a certain embodiment, the second filling member 520 may be omitted.

**[Table 1]**

| First filling member (100Mpa) | | Panel slip (µm) | Panel stress (strain) |
|---|---|---|---|
| Comparative example | | 43 | 8.98E-3 |
| Disclosure | Second filling member omitted | 223 | 8.98E-4 |
| | Second filling m ember (1Mpa) | 207 | 1.94E-3 |
| | Second filling member (10Mpa) | 207 | 4.93E-3 |

The above Table 1 represents comparative values of a panel slip amount and a panel stress in case that the second filling member 520 is omitted in the second space 400b, or the second filling members 520 having the molding modulus values of 1 Mpa and 10 Mpa are applied in the second space 400b, as compared with a comparative example in which the first filling member 510 is applied up to the second space 400b in a state where the first filling member 521 having the molding modulus value of 100 Mpa is applied in the first space 400a. For example, as compared with the comparative example, in case that the second filling member 520 is not applied, or the second filling member 520 having a smaller molding modulus value than that of the first filling member 510 is applied in the second space 400b, it can be understood that the panel stress is reduced to about 50% to 90%. This may mean that if the second filling member 520 is omitted, or the second filling member 520 having the smaller molding modulus value than that of the first filling member 510 is applied in the second space 400b, the panel slip amount is relatively increased, and the inferiority phenomenon, such as the buckling phenomenon, is reduced near the first edge 401 of the first display 400.

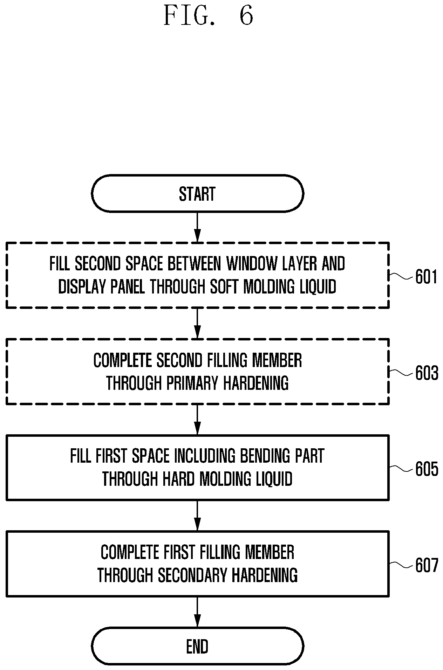

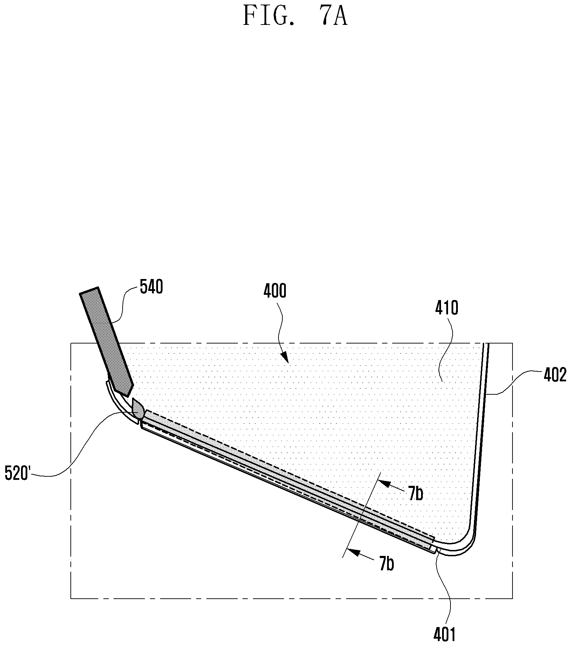

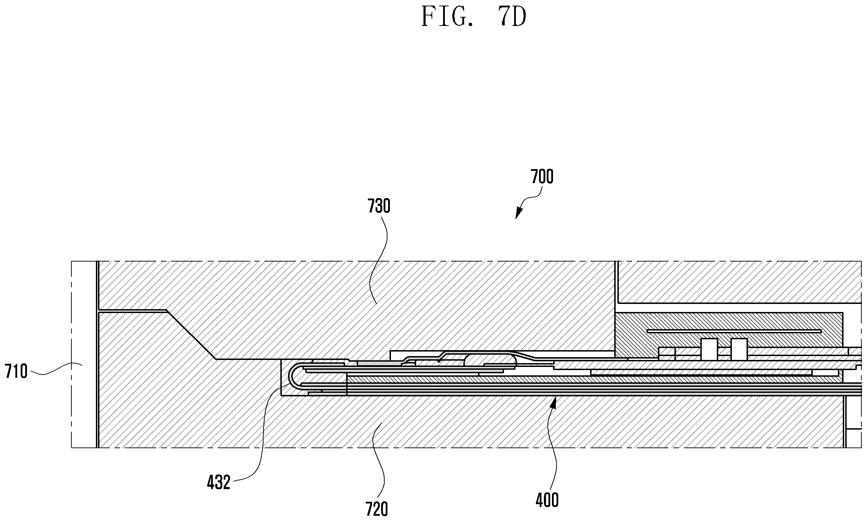

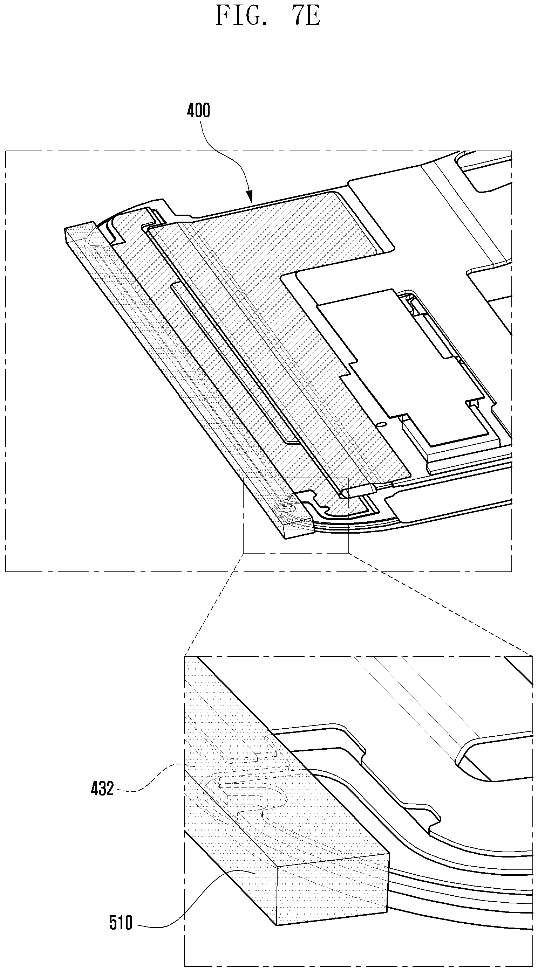

FIG. 6 is a process chart for applying filling members to a flexible display according to various embodiments of the disclosure. FIGS. 7A to 7E are schematic diagrams illustrating a process for applying filling members to a flexible display according to various embodiments of the disclosure.

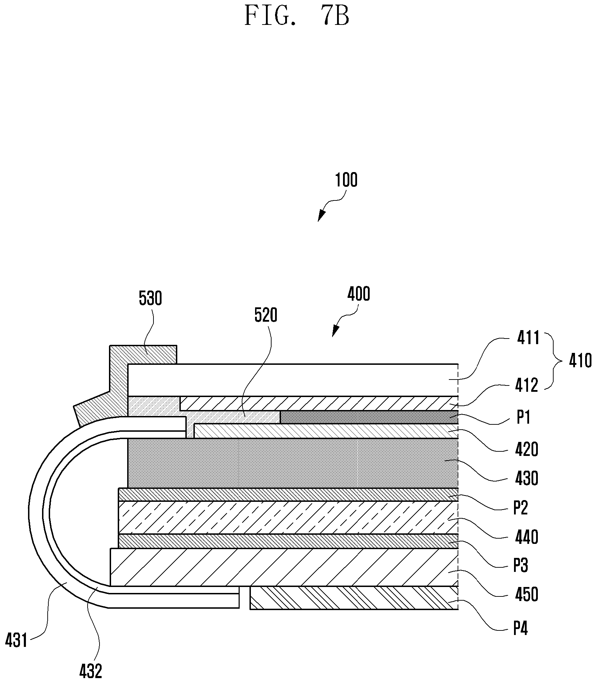

With reference to FIGS. 6 to 7E and 5, a first process 601 may include an operation of filling the second space 400b between the window layer 410 and the display panel 430 of the first display 400withthe molding liquid 520'. According to an embodiment, as illustrated in FIGS. 7A and 7B, a guide tape 530 may be attached so as to close the second space 400bbetween the bending part 432 and the window layer 410 along a length direction at the first edge 401 of the first display 400. According to an embodiment, in a state where the guide tape 530 is attached, the molding liquid 520' may be injected into one end of the first edge 401 of the first display 400 through the molding injector 540. In this case, the outside of the bending part 432 may be protected from the primary molding process by the guide tape 530. According to an embodiment, after the molding liquid injection is completed, in a second process 603, the second filling member may be completed by curing the molding liquid injected through at least one of the natural curing, heat curing, or UV curing. Thereafter, the guide tape 530 may be removed. In a certain embodiment, in case that the second filling member 520 excluded from being disposed in the second space 400b, the first process 610 and the second process 620 may be omitted.

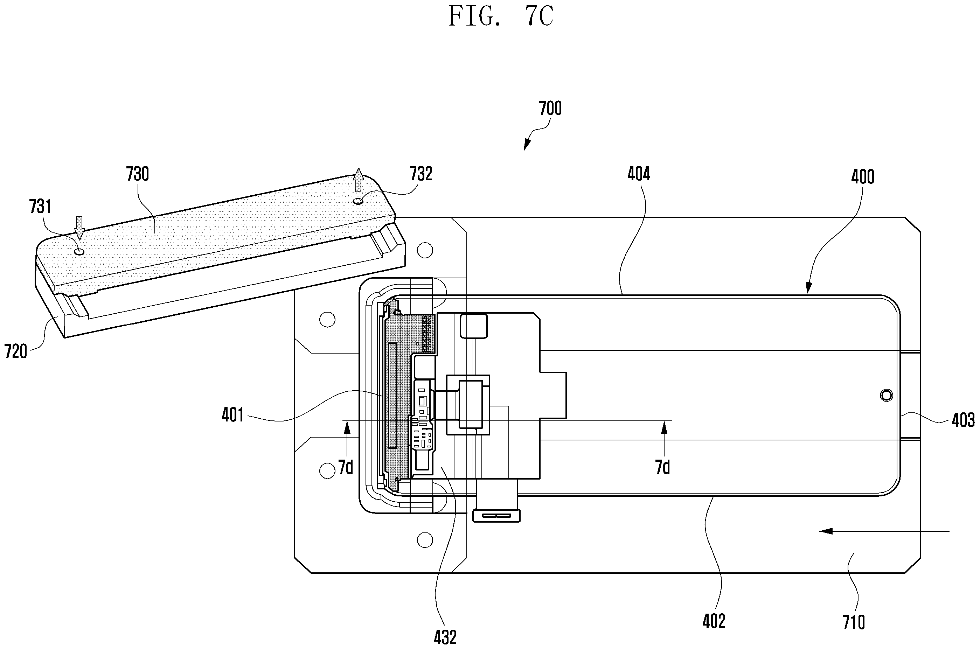

According to various embodiments, a third process 605 may include an operation of filling the first space 400a including the bending part 432 through the hard molding liquid. According to an embodiment, as illustrated in FIGS. 7C to 7E, the first display 400 including the second filling member 520 disposed in the second space 400b through curing of the primary molding liquid may be aligned with a molding jig 710 (e.g., Teflon jig) of molding equipment 700. In this case, the first edge 401 of the first display 400 may be disposed between a lower mold 720 and an upper mold 730 at the molding jig 710. According to an embodiment, the lower mold 720 and the upper mold 730 may be formed of a silicone material. For example, the upper mold 730 may include an inlet 731 for injecting the molding liquid and an outlet 732 for discharging the over-injected molding liquid. According to an embodiment, the inlet 731 and the outlet 732 may be disposed at locations corresponding to both end parts of the first space 400a along the length direction at the first edge 401 of the first display 400. For example, in a fourth process 607, if the molding liquid is injected into the inlet 731 of the upper mold 730, the first space 400a including the bending part 432 of the first display 400 may be filled with the molding liquid, and the molding liquid may be cured through at least one of the natural curing, heat curing, or UV curing. Thereafter, if the lower mold 720 and the upper mold 730 are separated from each other, and the first display 400 is separated from the molding jig 710, the first filling member 510 may maintain a fixed state so as to surround at least the bending part 432 at the first edge 401 of the first display 400. In a certain embodiment, when the first display 400 is disposed in the electronic device 100, the first filling member 510 may be formed with a size and/or a shape that can be supported by the second lateral member 123 of the second housing 120.

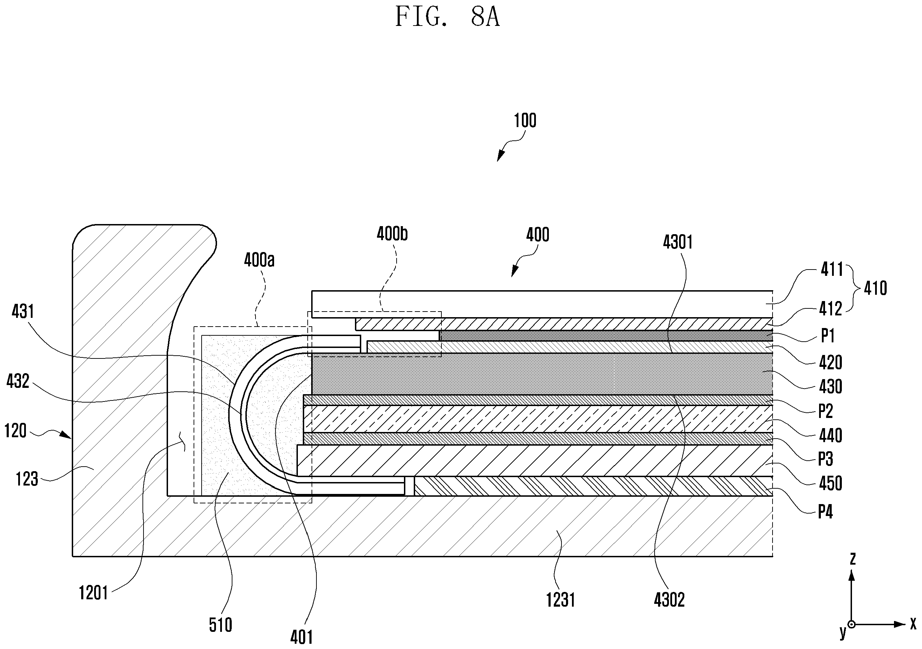

FIGS. 8A to 8C are partial cross-sectional views of an electronic device according to various embodiments of the disclosure.

In describing an electronic device of FIGS. 8A to 8C, the same reference numerals are used for the constituent elements substantially the same as those of the electronic device 200 of FIG. 5, and the detailed explanation thereof may be omitted.

With reference to FIG. 8A, the electronic device 100 may include the first filling member 510 disposed in the first space 400a including at least the bending part 432. In this case, since the second space 400b between the window layer 410 and the display panel 430 does not include any filling member, it may accommodate the slip phenomenon between the layers of the first display 400 in accordance with the folding/unfolding operation of the electronic device 100, and thus help the reduction of the inferiority, such as the buckling phenomenon.

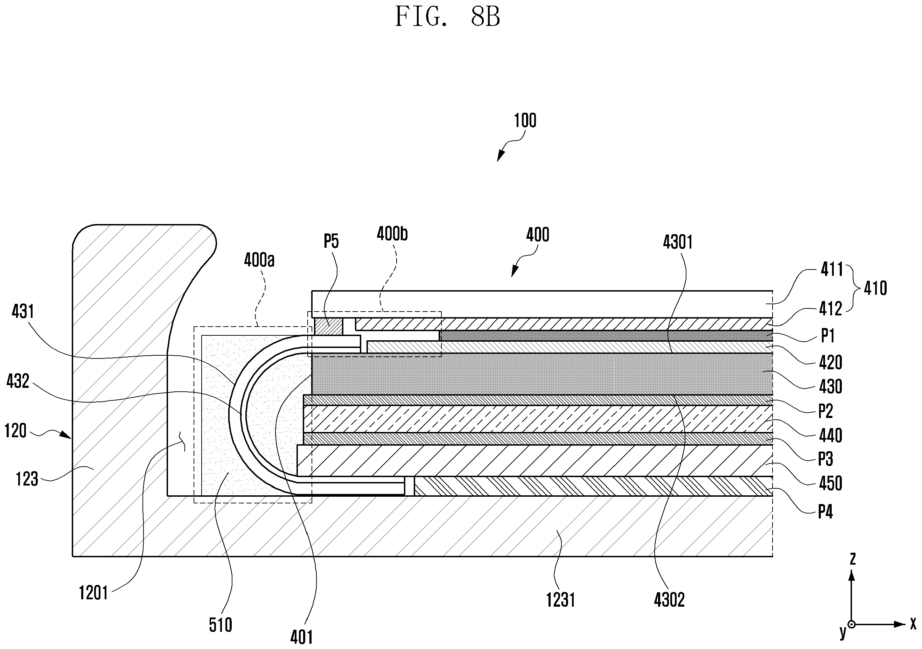

With reference to FIG. 8B, the electronic device 100 may include the first filling member 510 disposed in the first space 400a including at least the bending part 432. In this case, the second space 400b between the window layer 410 and the display panel 430 may not include any filling member. According to an embodiment, the second space 400b may be sealed by the adhesive member P5 disposed between the window layer 410 and the display panel 430. According to an embodiment, since the penetration of the external foreign substances and/or moisture can be prevented through the sealing structure of the second space 400b by the adhesive member P5, the sealing structure can improve the waterproof performance, and help solve the ESD problem.

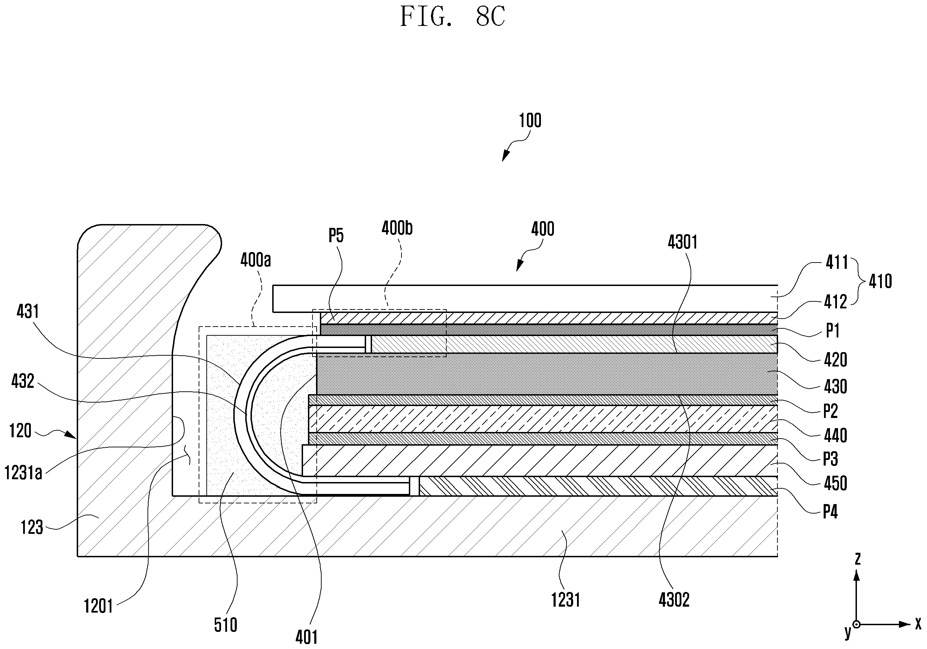

With reference to FIG. 8C, the electronic device 100 may include the first filling member 510 disposed in the first space 400a including at least the bending part 432. In this case, the second space 400b between the window layer 410 and the display panel 430 may not include any filling member. According to an embodiment, the second space 400b may be sealed since at least a part of the window layer 410 extends together with the adhesive member, and is attached to the bending part 432 through the adhesive member. For example, when the flexible display is viewed from above, the second space400b may help the sealing structure in a manner that the glass layer (UTG) of the window layer and the end part of the adhesive member extend up to at least a part of the bending part to overlap each other. Since the sealing structure can prevent the penetration of the external foreign substances and/or moisture, it can improve the waterproof performance, and help solve the ESD problem.

According to various embodiments, an electronic device (e.g., the electronic device 100 of FIG. 3) may include: a first housing (e.g., the first housing 110 of FIG. 3); a second housing (e.g., the second housing 120 of FIG. 3) connected in a foldable manner to the first housing by a hinge device (e.g., the hinge device 140 of FIG. 3); and a flexible display (e.g., the first display 400 of FIG. 5) disposed to be supported by the first housing and the second housing. The flexible display may include: a window layer (e.g., the window layer 410 of FIG. 5); a display panel (e.g., the display panel 430 of FIG. 5) laminated under the window layer; a bending part (e.g., the bending part 432 of FIG. 5) bent from the display panel to a rear surface of the flexible display at a first edge (e.g., the first edge 401 of FIG. 5) of the flexible display; and a first filling member (e.g., the first filling member 510 of FIG. 5) disposed in a first space (e.g., the first space 400a of FIG. 5) surrounding at least a part of the first edge together with the bending part. The first filling member may not be disposed within a second space (e.g., the second space 400b of FIG. 5) between the window layer and the display panel.

According to various embodiments, the first space and the second space may not overlap each other in a view of the flexible display from above.

According to various embodiments, the first filling member may be formed of a cured molding solution that is injected.

According to various embodiments, the electronic device may further include a polymer layer disposed under the display panel, and a support plate disposed under the polymer layer.

According to various embodiments, an edge of the polymer layer may be disposed closer to the bending part than an edge of the display panel at the first edge. For example, the first edge faces in a first direction towards the bending part, and, at the first edge, an edge of the polymer layer that faces in the first direction is a further in the first direction than an edge of the display panel that faces in the first direction.

According to various embodiments, an edge of the support plate may be disposed closer to the bending part than the edge of the polymer layer at the first edge. For example, at the first edge, an edge of the support plate that faces in the first direction is a further in the first direction than an edge of the polymer layer that faces in the first direction.

According to various embodiments, the second space may be blocked by an adhesive member disposed between at least a part of the window layer and the bending part at the first edge.

According to various embodiments, the window layer may include a first layer of a polymer material and a second layer of a glass material disposed between at least a part of the first layer and the bending part, wherein the second space may be blocked by an adhesive member disposed between at least a part of the first layer and the bending part at the first edge.

According to various embodiments, the first filling member may have a molding modulus value equal to or larger than 100 Mpa.

According to various embodiments, the electronic device may include a second filling member disposed in the second space.

According to various embodiments, the second filling member may be formed of a cured molding solution that is injected .

According to various embodiments, the second filling member may have a molding modulus value equal to or smaller than 10 Mpa.

According to various embodiments, the first housing may include a first lateral member forming at least a part of a side surface of the electronic device and a first support member extending from the first lateral member, wherein the second housing may include a second lateral member forming at least another part of the side surface of the electronic device and a second support member extending from the second lateral member, and wherein the flexible display may be disposed to be supported by the first support member and the second support member.

According to various embodiments, the first filling member may be disposed in a space between the second lateral member and the second support member.

According to various embodiments, a size and/or a shape of the first filling member may be defined by the space between the second lateral member and the second support member.

According to various embodiments, an electronic device (e.g., the electronic device 100 of FIG. 3) may include: a first housing (e.g., the first housing 110 of FIG. 3); a second housing (e.g., the second housing 120 of FIG. 3) connected in a foldable manner to the first housing bya hinge device (e.g., the hinge device 140 of FIG. 3); and a flexible display (e.g., the first display 400 of FIG. 5) disposed to be supported by the first housing and the second housing. The flexible display may include: a window layer (e.g., the window layer 410 of FIG. 5); a display panel (e.g., the display panel 430 of FIG. 5) laminated under the window layer; a bending part (e.g., the bending part 432 of FIG. 5) bent from the display panel to a rear surface of the flexible display at a first edge (e.g., the first edge 401 of FIG. 5) of the flexible display; a first filling member (e.g., the first filling member 510 of FIG. 5) disposed in a first space (e.g., the first space 400a of FIG. 5) surrounding at least a part of the first edge together with the bending part; and a second filling member (e.g., the second filling member 520 of FIG. 5) disposed in a second space (e.g., the second space 400b of FIG. 5) between the window layer and the display panel, and having a molding modulus value that is smaller than a molding modulus value of the first filling member.

According to various embodiments, the first space and the second space may not overlap each other in a view of the flexible display from above.

According to various embodiments, the first filling member may be formed to have a molding modulus value equal to or larger than 100 Mpa.

According to various embodiments, the second filling member may be formed to have a molding modulus value equal to or smaller than 10 Mpa.

According to various embodiments, the electronic device may include at least two layers disposed under the display panel, wherein the first edge faces in a first direction towards the bending part, and wherein, at the first edge, edges of the at least two layers that face in the first directions towards the bending part are farther in the first direction the farther the at least two layers are away from the display panel.

Example embodiments of the disclosure that are described in the specification and shown in the drawings are to merely present specific non-limiting examples for easy explanation of the technical contents according to the embodiments of the disclosure and to help understanding of the embodiments of the disclosure, and are not intended to limit the scope of the embodiments of the disclosure. Accordingly, it should be interpreted that all changes or modifications derived based on the technical idea of various embodiments of the disclosure are included in the scope of the present disclosure, in addition to the embodiments described herein.

## Claims

1. An electronic device (100) comprising:
a first housing (110);
a second housing (120);
a hinge device (140) connecting the first housing and the second housing to be foldable relative to each other; and
a flexible display (400) supported by the first housing and the second housing,
wherein the flexible display (400) comprises:
a window layer (410);
a display panel (430) laminated under the window layer;
a bending part (432) bent from the display panel to a rear surface of the flexible display at a first edge (401) of the flexible display; and
a first filling member (510) in a first space (400a), within the electronic device, such as to surround at least a part of the first edge together with the bending part,
wherein the first filling member is not within a second space (400b) between the window layer and the display panel.

2. The electronic device of claim 1, wherein the first space and the second space do not overlap each other in a view of the flexible display from above.

3. The electronic device of claim 1 or 2, wherein the first filling member comprises a molding solution that is cured.

4. The electronic device of any one of claims 1 to 3, further comprising:
a polymer layer (440) under the display panel; and
a support plate (450) under the polymer layer.

5. The electronic device of claim 4, wherein the first edge faces in a first direction towards the bending part, and
wherein, at the first edge, an edge of the polymer layer that faces in the first direction is further in the first direction than an edge of the display panel that faces in the first direction.

6. The electronic device of claim 4 or 5, wherein the first edge faces in a first direction towards the bending part, and
wherein, at the first edge, an edge of the support plate that faces in the first direction is further in the first direction than an edge of the polymer layer that faces in the first direction.

7. The electronic device of any one of claims 1 to 3, further comprising an adhesive member (P5) between at least a part of the window layer and the bending part at the first edge and blocking the second space.

8. The electronic device of any one of claims 1 to 3, wherein the window layer comprises a first layer (411) of a polymer material and a second layer (412) of a glass material,
wherein the second layer is between the first layer and the bending part, and
wherein the electronic device further comprises an adhesive member (P5) between at least a part of the first layer and the bending part at the first edge and blocking the second space.

9. The electronic device of any one of claims 1 to 3, wherein the first filling member has a molding modulus value that is equal to or larger than 100 Mpa.

10. The electronic device of any one of claims 1 to 3, comprising a second filling member (520) within the second space.

11. The electronic device of claim 10, wherein the second filling member comprises a cured molding solution.

12. The electronic device of claim 10 or 11, wherein the second filling member has a molding modulus value equal to or smaller than 10 Mpa.

13. The electronic device of any one of claims 1 to 3, wherein the first housing comprises:
a first lateral member (113) that forms at least a part of a side surface of the electronic device; and
a first support member (1131) that extends from the first lateral member,
wherein the second housing comprises:
a second lateral member (123) that forms at least another part of the side surface of the electronic device; and
a second support member (1231) that extends from the second lateral member, and
wherein the flexible display is supported by the first support member and the second support member.

14. The electronic device of claim 13, wherein the first filling member is within a space (1201) between the second lateral member and the second support member.

15. The electronic device of claim 13 or 14, wherein a size or a shape of the first filling member is defined by a space between the second lateral member and the second support member.

16. An electronic device comprising:
a first housing (110);
a second housing (120);
a hinge device (140) connecting the first housing (110) and the second housing (120) to be foldable relative to each other; and
a flexible display (400) disposed to be supported by the first housing and the second housing,
wherein the flexible display includes:
a window layer (410);
a display panel (430) laminated under the window layer;
a bending part (432) bent from the display panel to a rear surface of the flexible display at a first edge (401) of the flexible display;
a first filling member (510) disposed in a first space (400a) surrounding at least a part of the first edge together with the bending part; and
a second filling member (520) disposed in a second space (400b) between the window layer and the display panel, and having a molding modulus value that is smaller than that of the first filling member.

17. The electronic device of claim 16, wherein the first space and the second space do not overlap each other in case that the flexible display is viewed from above.

18. The electronic device of claim 16 or 17, wherein the first filling member is formed to have a molding modulus value equal to or larger than 100 Mpa.

19. The electronic device of any one of claims 16 to 18, wherein the second filling member is formed to have a molding modulus value equal to or smaller than 10 Mpa.

20. The electronic device of any one of claims 16 to 19, comprising at least two layers (440, 450) disposed under the display panel,
wherein edges of the layers are disposed closer to the bending part as getting farther away from the display panel.
